# FASCICULE DE BREVET EUROPEEN

(11) **EP 2 663 665 B1**
(45) Date de publication et mention de la délivrance du brevet: **11.03.2015**
(21) Numéro de dépôt: 12700188.1
(22) Date de dépôt: 12.01.2012
(51) Int. Cl.: C23C 14/16, C23C 14/24, C23C 14/56

(54) **DISPOSITIF D'ALIMENTATION AUTOMATIQUE D'UN GENERATEUR DE VAPEUR METALLIQUE INDUSTRIEL**
AUTOMATISCHE ZUFUHRVORRICHTUNG FÜR EINEN INDUSTRIELLEN METALLDAMPFGENERATOR
AUTOMATIC FEEDING DEVICE FOR AN INDUSTRIAL METAL-VAPOR GENERATOR

(30) Priorité: 14.01.2011 EP 11151004
(43) Date de publication de la demande: 20.11.2013
(73) Titulaire: Arcelormittal Investigacion y Desarrollo, 48910 Sestao, Bizkaia (ES)
(72) Inventeur: BANASZAK, Pierre, B-4683 Vivegnis (BE); MARNEFFE, Didier, B-4480 Engis (BE); SCHMITZ, Bruno, B-4550 Nandrin (BE); SILBERBERG, Eric, B-5340 Haltinne-Gesves (BE); VANHEE, Luc, F-62860 Oisy-le-Verger (FR)
(74) Mandataire: Blot, Philippe Robert Emile
(86) Numéro de dépôt international: PCT/EP2012/050432
(87) Numéro de publication internationale: WO 2012/095489

(56) Documents cités:
- EP-A1- 1 972 699
- EP-A1- 2 048 261
- WO-A1-2005/116290

## Description

### Objet de l'invention

La présente invention se rapporte à un dispositif d'alimentation automatique en métal liquide d'un générateur de vapeur industriel. Celui-ci est utilisé pour revêtir sous vide et en continu une bande métallique en mouvement, au moyen de vapeur métallique, en vue de former une couche de métal et de préférence une couche d'alliage métallique sur sa surface, de manière à lui assurer une excellente résistance à la corrosion tout en conservant de bonnes caractéristiques d'emboutissage et de soudabilité.

L'invention s'inscrit dans la continuité des demandes antérieures EP 1 972 699 et EP 2 048 261 relatives à des générateurs de vapeur métallique par jet de vapeur sonique ou JVD (pour *Jet Vapor Deposition*)*.* Plus particulièrement, EP 1 972 699 décrit un procédé et un équipement de revêtement par JVD alimenté en vapeur au moyen d'un four et d'un creuset d'évaporation reliés entre eux par des conduites d'alimentation et de retour, permettant de déposer des alliages métalliques. EP 2 048 261 décrit un générateur de vapeur comprenant un four et un creuset évaporateur reliés par une conduite d'alimentation et comprenant également des moyens de réglage du débit, de la pression et/ou de la vitesse de la vapeur métallique au niveau de la tête de dépôt par JVD. On connaît également WO 2005/116290 qui décrit une installation de dépôt sous vide par évaporation comprenant un creuset de fusion et au moins un creuset d'évaporation reliés par une conduite chauffée, munie d'un système magnétohydrodynamique permettant de maintenir le métal fondu à un niveau constant dans le creuset d'évaporation.

### Arrière-plan technologique et état de la technique

Comme décrit dans les demandes précitées, on génère de la vapeur au départ d'un creuset chauffé par induction. L'énergie injectée à laquelle on soustrait les pertes correspond au volume molaire d'évaporation. La corrélation est parfaitement linéaire.

Ce générateur de vapeur doit être alimenté en métal afin de compenser les volumes évaporés. Après avoir examiné différents modes d'alimentation, l'alimentation en métal liquide a été retenue. En effet, sur une ligne industrielle en continu, l'alimentation doit être automatique. En ligne sidérurgique de revêtement au moyen de magnésium ou de zinc, le dépôt sur bande implique des centaines de kg, voire des tonnes de métal par heure. L'alimentation du creuset ne peut être directement sous forme solide (fil, granules, lingots, etc.), car cela exigerait par exemple l'utilisation d'un système à sas avec des compartiments sous vide, ce qui est trop complexe. Dans la présente technologie, le creuset est alimenté en métal liquide pompé dans une conduite à partir d'un four de fusion situé en contrebas du creuset et se trouvant à la pression atmosphérique.

Par ailleurs, dans le creuset ne vont s'évaporer que les espèces pour lesquelles la pression de vapeur saturante obtenue permet l'évaporation. Les autres espèces vont rester dans le creuset et s'y accumuler. Il s'agit d'une forme de distillation. Toutes les impuretés non évaporables ou difficilement évaporables contenues dans le métal de base (qui n'est pas pur à 100% pour des raisons de coûts) vont ainsi s'accumuler dans le creuset. Leur concentration va finir par gêner voire même empêcher l'évaporation. Ces impuretés doivent donc être éliminées périodiquement ou continuellement.

Parmi les matières qui pourraient s'accumuler dans le creuset d'évaporation, il y a en particulier les oxydes métalliques du métal de base. Ces oxydes proviennent principalement du métal d'apport généralement acheté en lingots dont la surface externe est oxydée. Une simulation numérique sur un prototype industriel de capacité d'évaporation modérée a montré que le taux de concentration en impuretés pouvait atteindre 10% et ceci après 40 heures de production et en considérant un matériau de base de pureté de 99,8% (magnésium). Les oxydes présents peuvent soit décanter soit surnager du fait de leur séparation du métal de base par ségrégation. Dans ce second mode de séparation, ils peuvent fortement influencer l'évaporation.

Avec les générateurs de vapeur de ce type d'installation se posent donc les problèmes ou exigences suivants :
- démarrage de l'installation alors que le creuset d'évaporation est vide ;
- empêchement, lors de la mise en route, en cas de fuite par une vanne de distribution de vapeur, de l'évaporation du métal dans la conduite, vers la tête de dépôt sous vide. Ces fuites sont très dommageables car elles entraînent des dépôts statiques sur la bande en standby (sous forme de bourrelets). De plus, pallier le débit d'évaporation, et la grande quantité d'énergie prise au métal (chaleur latente d'évaporation), nécessite une forte puissance additionnelle. Pour empêcher le refroidissement du métal liquide, il faudrait installer une puissance considérable sur toute la longueur des conduites liquides, ce qui s'avère techniquement impossible étant donné la densité de puissance par unité de surface qu'il faudrait installer ;

- démarrage du four de fusion et empêchement de l'évaporation du métal sous l'effet du vide ;
- éviter la formation d'un bouchon solide à la surface libre du four et dans les conduites, du fait de l'évaporation et qui empêcherait la transformation sous forme liquide et l'alimentation du creuset ;
- empêchement de la solidification du métal dans la conduite d'alimentation, ce qui conduirait sinon, lors de la refusion, à une rupture de la conduite sous l'effet de la dilatation du métal ;
- vidange des conduites contenant le liquide afin de pouvoir éviter ce qui précède et afin de pouvoir démonter les conduites pour en faire la maintenance ;
- mise en service du four de fusion qui nécessite plus de 10 heures de chauffage, sans avoir à chauffer tout le reste de l'installation ou avoir à faire le vide. En effet, le chauffage nécessaire du reste de l'installation pour éviter la condensation des vapeurs sur paroi froide est beaucoup plus court (par ex. 2 heures) ;
- permettre de solidifier dans les conduites sans les casser.

### Buts de l'invention

La présente invention vise à s'affranchir des inconvénients de l'état de la technique.

La présente invention a pour but d'alimenter le creuset d'évaporation à partir du four de fusion, tout en assurant la recirculation du métal liquide, dans des conditions de sécurité et de qualité optimales.

L'invention a encore pour but de mettre en service, dans un premier temps, le four de fusion sans avoir à faire le vide ou chauffer le reste de l'installation, qui sert à l'évaporation.

L'invention a encore pour but de permettre un démarrage et un arrêt aisés de l'installation.

L'invention a encore pour but de permettre la solidification du métal liquide sans créer un bouchon solide à la surface libre du four ou dans les conduites d'alimentation avec risque de casse de celles-ci lors de la refusion, suite à la dilatation du métal.

### Principaux éléments caractéristiques de l'invention

La présente invention se rapporte à une installation de dépôt sous vide en continu d'un revêtement métallique sur un substrat en défilement, comprenant une enceinte de dépôt sous vide, au moins une tête de revêtement par jet de vapeur sonique reliée à un creuset évaporateur destiné à contenir le métal de revêtement sous forme liquide par une conduite d'alimentation en vapeur munie d'une vanne de distribution, et un four de fusion dudit métal, ledit four se trouvant à la pression atmosphérique, étant situé en contrebas de la partie la plus basse du creuset évaporateur et étant relié au creuset évaporateur par au moins une conduite d'alimentation automatique du creuset évaporateur munie d'une pompe d'alimentation et par au moins une conduite de retour du métal liquide optionnellement munie d'une vanne, des moyens de régulation de la pompe d'alimentation étant en outre présents pour réguler un niveau de métal liquide déterminé dans le creuset évaporateur, l'installation comprenant, dans chacune desdites conduites d'alimentation et de retour, une zone appelée vanne thermique munie d'un dispositif de chauffage et d'un dispositif de refroidissement pour obtenir une température régulée, indépendante de celle du four de fusion, de celle régnant dans la partie restante desdites conduites et dans le creuset évaporateur, pour fondre ou solidifier le métal se trouvant à cet endroit.

Dans le cadre de la présente invention, on utilise le procédé de revêtement par jet de vapeur sonique, tel qu'il est en particulier décrit dans le brevet EP 909 342.

Selon des modes particuliers de réalisation de l'invention, l'installation comporte en outre une ou une combinaison appropriée des caractéristiques suivantes :
- l'installation comprend des moyens permettant de générer de la vapeur métallique de façon localisée, entre le four et la tête de revêtement ;
- l'installation comprend un dispositif de rétention de métal liquide situé dans le fond du creuset évaporateur, pour générer de manière localisée une vapeur métallique ;
- l'installation comprend un creuset d'appoint relié à la conduite d'alimentation en vapeur, pour générer de manière localisée une vapeur métallique ;
- ladite ou lesdites vannes thermiques sont constituées d'une double enveloppe, dans laquelle se fait le refroidissement par injection et circulation de fluide froid ;
- la conduite d'alimentation est munie d'une vanne de dérivation permettant l'utilisation de la conduite d'alimentation comme tube de vidange ;
- lesdites conduites sont réalisées en bi-matière, l'intérieur étant constitué d'un tube sans soudure en acier à bas carbone, en graphite ou en sialon, revêtu extérieurement par de l'acier inoxydable ;
- les tubes sont placés dans une seconde enveloppe métallique en forme de soufflet ;
- la liaison entre le four de fusion et le creuset évaporateur est assurée par une barre de référence rigide et les conduites sont réalisées en forme de lyre ;
- les conduites sont fixées entre elles ainsi qu'au four et au creuset évaporateur par des brides en métal, l'étanchéité au vide étant obtenue par superposition d'un joint métallique gonflable et d'un joint en graphite ;
- le creuset évaporateur est en communication avec un dispositif de distribution de gaz inerte, pour repousser grâce à sa pression le métal liquide jusque dans le four de fusion.

La présente invention se rapporte également à un procédé de démarrage d'une installation comme décrite ci-dessus, selon lequel :
- on démarre la fusion du métal dans le four, tout en maintenant du métal à l'état solide dans les vannes thermiques des conduites d'alimentation et de retour ;
- on chauffe le reste de ladite installation jusqu'à la température nécessaire pour recevoir le métal liquide et/ou la vapeur métallique, on ferme la vanne de distribution de la conduite d'alimentation, et on met l'enceinte de dépôt sous vide ;
- on active lesdits moyens permettant de générer de la vapeur métallique de façon localisée, à une température supérieure à celle du métal liquide dans l'installation en cours de dépôt ;
- on fait fondre le métal solidifié contenu dans les vannes thermiques ;
- on remplit ensuite le creuset évaporateur grâce à la pompe d'alimentation, on ouvre la vanne de distribution de la conduite d'alimentation, et on commence le dépôt de métal sur ledit substrat en défilement.

Avantageusement, la hauteur du creuset évaporateur relativement au four de fusion est déterminée pour que la surface libre de métal liquide dans la conduite d'alimentation soit située en dessous du creuset, lorsque le vide est réalisé dans l'installation, la pompe d'alimentation n'étant pas en fonctionnement.

L'invention se rapporte enfin à un procédé de mis en oeuvre de l'installation telle que décrite ci-dessus, pour lequel le substrat est une bande métallique et le revêtement métallique est constitué de magnésium ou de zinc.

### Brève description des figures

La figure 1 représente schématiquement une vue d'ensemble du générateur de vapeur métallique industriel selon la présente invention.

La figure 2 représente schématiquement un mode d'exécution du four de fusion dudit générateur.

La figure 3 représente schématiquement un mode d'exécution du creuset d'évaporation dudit générateur.

La figure 4 représente une vue en coupe d'un exemple de conduite conçue pour le magnésium liquide.

### Description de formes d'exécution préférées de l'invention

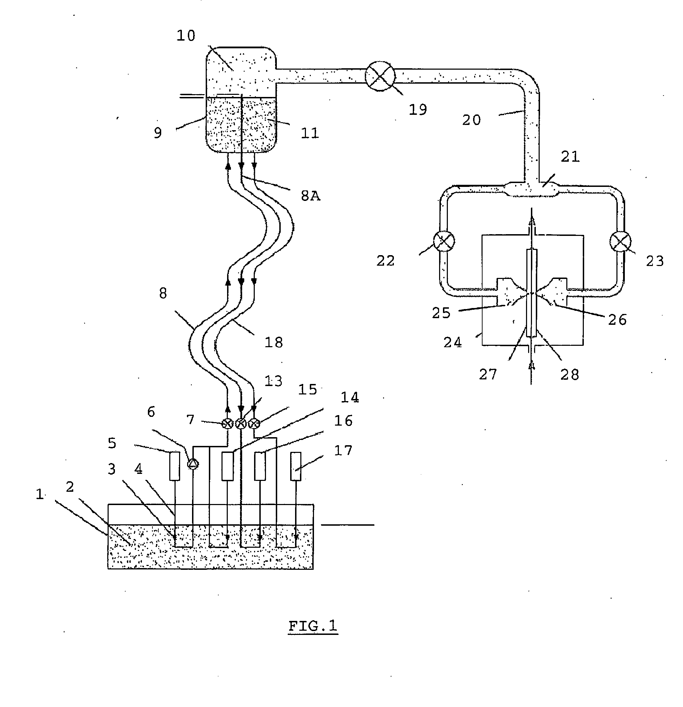

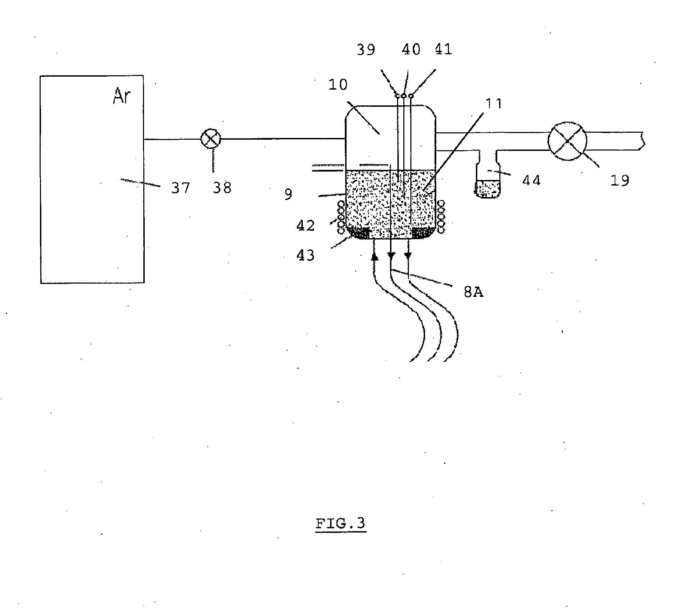

Le montage et l'utilisation de l'installation peuvent être réalisés de différentes façons. On se référera ci-après aux FIG.1 et 3 qui décrivent un mode de réalisation préféré d'une installation de dépôt de magnésium ou de zinc sur une bande d'acier défilant en continu. L'installation comporte donc un générateur de vapeur muni d'au moins un creuset d'évaporation (ou creuset évaporateur) sous vide 9 chauffé par induction et alimenté par un four de fusion 1. Entre le four de fusion 1 et le creuset évaporateur 9 sont disposées des conduites 8, 8A, 18 permettant non seulement l'alimentation de renouvellement du creuset 9 en métal à évaporer 2 mais aussi une recirculation continue ou non entre les deux équipements que sont le four de fusion 1 et le creuset évaporateur 9. Le creuset évaporateur 9 est relié à la tête de revêtement par une conduite d'alimentation en vapeur 20 contenant au moins une vanne de distribution de vapeur 19 permettant d'isoler le creuset évaporateur 9 de l'enceinte de dépôt sous vide 24.

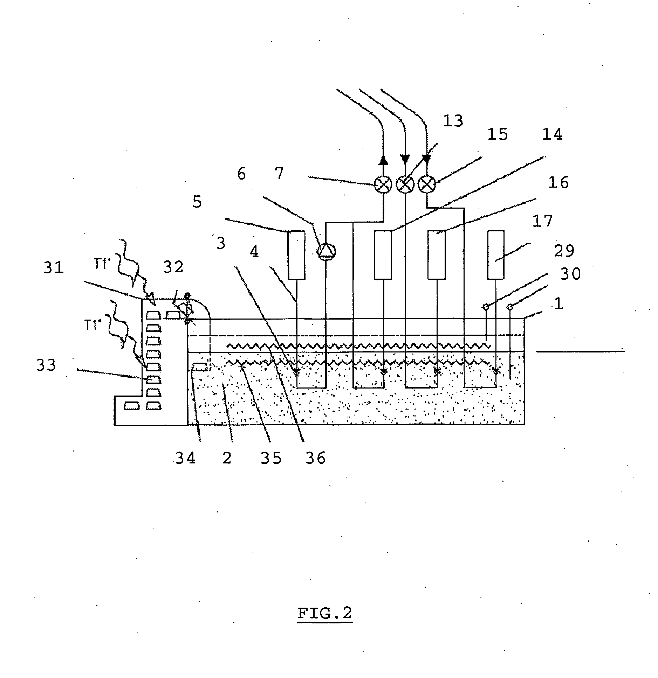

Le four de fusion 1, représenté sur la FIG.2, est alimenté en métal solide, par exemple sous forme de lingots 33, 34 au travers d'un dispositif d'alimentation automatique 31, 32 avec préchauffage des lingots pour empêcher toute entrée d'humidité dans le four.

Le four de fusion 1 a de préférence une capacité (en kg/h) supérieure au débit massique du creuset évaporateur 9, le ratio entre la capacité du four et le débit de l'évaporateur étant de préférence compris entre 2 et 25 et de façon plus particulièrement préférée entre 10 et 25. On peut de la sorte assurer une très bonne uniformité en température même lors de la fusion d'un ou de nouveaux lingots 34. On peut choisir par exemple une capacité de 800 kg/h pour un besoin de 50 à 100 kg/h au niveau de l'évaporation.

Le four de fusion 1 a en outre, de préférence, une contenance (en m³ ou kg) supérieure à la contenance du creuset évaporateur 9 et donc grande par rapport au débit de recirculation. Le ratio entre la contenance du four de fusion et la contenance du creuset est de préférence compris entre 2 et 10 et de façon plus particulièrement préférée entre 5 et 10. On a par exemple choisi, pour le prototype considéré ici, un four de 800 kg pour une contenance du creuset d'évaporation de 250 kg.

Le fait que le four de fusion soit de grande capacité comparativement au creuset évaporateur et au débit de recirculation implique que l'on n'a pas ou quasi pas d'agitation dans le four. Il y a ainsi ségrégation des impuretés et décantation ou flottaison. Le fond et la surface du métal liquide contenu dans le four peuvent être régulièrement nettoyés pour éliminer les impuretés amenées par les lingots et les oxydes générés lors de la fusion des lingots. On réalisera alors de préférence un pompage en zone éloignée de la surface ou du fond pour alimenter le creuset évaporateur en métal relativement pur en y introduisant un minimum de polluants.

Dans un mode de réalisation préféré, le four de fusion 1 présente une gestion du chauffage différente en fonction de son niveau de remplissage:
- lorsque le four de fusion est plein (et donc que le creuset évaporateur est vide), on chauffe le four de fusion sur toute sa hauteur ;
- lorsque le four de fusion n'est pas plein (et donc que le creuset évaporateur est rempli), on chauffe le four de fusion sur toute la hauteur de remplissage, la partie haute étant simplement maintenue à température.

Dans le four de fusion, on distingue donc deux niveaux : un niveau plein et un niveau intermédiaire, c'est-à-dire un niveau obtenu en soustrayant au niveau plein le volume contenu dans le creuset évaporateur. Cela veut dire que les ajouts, automatiques ou non, de lingots doivent se faire en tenant compte de l'un ou de l'autre des niveaux et donc de l'état de fonctionnement de l'installation. Des sondes de niveau dans le four 29, 30 permettent de gérer les deux niveaux selon que le creuset d'évaporation est vide ou plein.

On notera également qu'il y a la place dans le four de fusion 1 pour le métal contenu dans le creuset évaporateur 9, ce qui permet de vidanger ce dernier.

Comme on l'a vu précédemment, l'installation selon l'invention comprend un creuset évaporateur 9 réalisé dans une matière adaptée à la nature du métal liquide qu'il contient. Dans le cas du magnésium, on pourra par exemple utiliser un creuset en acier doux, alors que dans le cas du zinc le creuset pourrait être réalisé en un matériau compatible tel que le graphite, les sialons (SiAlON ou *silicon-aluminum-oxygen-nitride*)*,* etc. Ce creuset est de préférence chauffé par un dispositif à induction 42 et peut comprendre, dans un mode de réalisation préféré, une mesure du niveau de métal liquide par des sondes électromagnétiques à haute fréquence 39, 40, 41 choisies pour avoir une fréquence distincte du dispositif de chauffage par induction 42.

Selon l'invention, le creuset d'évaporation 9 est relié au four 1 par au moins une conduite métallique d'alimentation 8 et par au moins une conduite de retour 8A, 18 permettant d'assurer une recirculation du métal liquide (FIG.1). La mise en oeuvre de cette recirculation entre le four 1 et le creuset d'évaporation 9 permet de réduire le taux d'impureté résiduel à une valeur de l'ordre de 2% pour une recirculation de quelques pour cent du débit d'alimentation. L'élimination des impuretés par recirculation permet ainsi de réaliser un équipement pouvant travailler 24 heures sur 24 sans interruption pour nettoyage du creuset d'évaporation.

La conduite d'alimentation 8 sert à acheminer le métal liquide du four 1 vers le creuset évaporateur 9. Elle est munie d'une pompe d'alimentation 6 qui tourne et régule sa vitesse pour assurer le débit permettant d'atteindre puis de maintenir le niveau souhaité. Afin de vidanger au plus vite le creuset 9, la sortie de la pompe d'alimentation 6 est de préférence équipée d'une vanne 14 permettant d'utiliser la conduite d'alimentation 8 du creuset en tube de vidange.

La ou les conduites de retour 8A, 18 servent à acheminer le métal liquide du creuset 9 vers le four 1. La conduite de retour 8A, 18 peut être équipée d'une vanne de retour 16, 17 à son extrémité. Cette vanne proportionnelle est ouverte totalement lors de la vidange du creuset. Elle est fermée totalement lors du remplissage afin de minimiser la durée de celui-ci. Elle est ouverte partiellement lors du revêtement afin de permettre un débit de fuite servant de débit de recirculation. Ce débit est réglé à chaque mise en service par une mesure de vitesse de vidange et ajustement de la position de la vanne.

Un type particulier de conduite de retour est une conduite de trop-plein 8A, afin de fixer le niveau maximal de métal liquide dans le four. Si le niveau dans le creuset 9 monte de manière excessive du fait d'un problème de mesure ou de gestion (ex. problème de fiabilité de la mesure de niveau), le trop-plein de métal liquide peut être redirigé vers le four de fusion 1 au travers de cette conduite, en toute sécurité.

Un autre type de conduite de retour est une conduite de recirculation 18, qui permet de faire circuler du métal liquide de façon continue ou discontinue lorsqu'il est nécessaire d'ajuster les niveaux.

Dans un mode de réalisation préféré, l'installation comprend deux conduites de retour 8A, 18, dont une conduite de trop-plein 8A et une conduite de recirculation 18, chacune pouvant être munie d'une vanne 16, 17.

Chacune des vannes précédemment décrites 14, 16, 17 est immergée dans le magnésium en fusion afin d'être protégée de l'air et afin de ne pas s'oxyder, et ainsi conserver ses propriétés, ses caractéristiques et sa propreté. Pour intervenir sur les vannes, il faut fondre le métal et sortir la vanne du métal liquide (à proprement parler, les symboles 14, 16 et 17 représentent sur les figures les commandes de ces vannes).

Comme mentionné précédemment, la présence d'une conduite de trop-plein 8A est optionnelle. On peut en effet adopter une régulation dans laquelle on impose le débit via la vitesse de la pompe d'alimentation 6 et on maintient le niveau de métal liquide via l'ouverture de la vanne de retour 17. L'installation selon ce mode de réalisation ne comporte donc qu'une conduite d'alimentation et une conduite de recirculation.

On pourrait également supprimer la conduite de recirculation 18 pour garder une conduite d'alimentation 8 et une conduite de trop-plein 8A. Le creuset évaporateur 9 ne nécessite alors plus de sonde de niveau 40 mais uniquement une pompe d'alimentation 6 à variateur de fréquence. La fréquence gère le débit de recirculation et le niveau correspond au trop-plein. Le remplissage et la vidange se font via la même conduite d'alimentation 8 qui est celle qui est équipée de la pompe d'alimentation 6.

Enfin, on pourrait également réguler, non pas par variateur de fréquence et donc par vitesse de rotation de la pompe d'alimentation 6, mais par débit de fuite en permettant à une partie du débit généré par la pompe d'alimentation 6 de rester dans le four en entrouvrant la vanne 14.

Le matériau dans lequel sont réalisées les différentes conduites utilisées dans l'installation selon l'invention est déterminé en fonction du métal à évaporer et du type de procédé retenu.

La conduite doit en effet être compatible avec le métal liquide qu'elle va contenir et ceci pour toute la gamme de température qui sera utilisée. Elle doit en outre être résistante mécaniquement et être étanche au vide. Elle doit conserver des propriétés mécaniques suffisantes même à haute température et doit résister extérieurement à la corrosion du fait de l'air à très haute température qui va l'entourer.

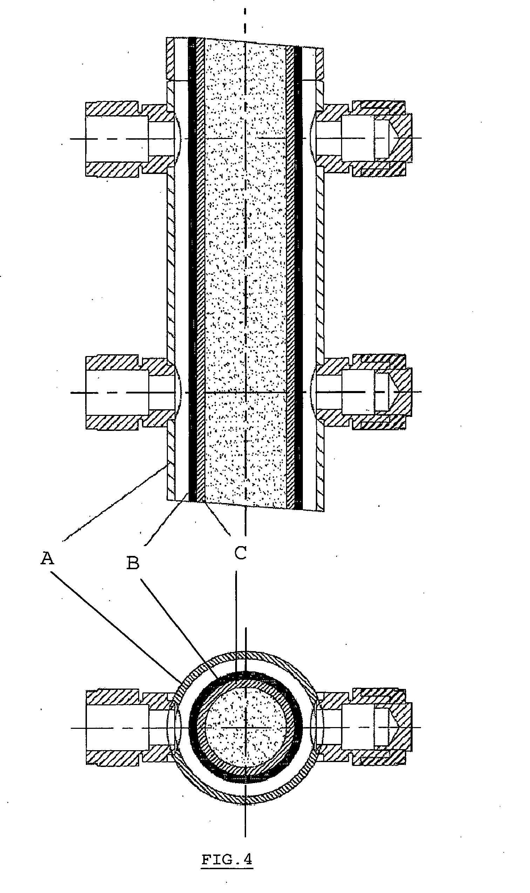

Dans le cas du revêtement par le magnésium, on pourra choisir une conduite en bi-matière (voir FIG.4). L'intérieur est constitué d'un tube C sans soudure en acier doux pour chaudière. En effet, ce type de tube convient parfaitement bien, le fer étant très difficilement soluble dans le magnésium liquide (de l'ordre de quelques ppm). L'extérieur B est constitué d'inconel. Cet inox est déposé par fusion sur le tube d'acier à bas carbone C avant d'être refusionné. Afin de limiter les contraintes mécaniques, une barre de référence très solide (non représentée) a été ajoutée et assure la liaison entre le four de fusion et le creuset d'évaporation. Elle se dilate de manière identique aux tubes et assure la reprise des principales contraintes mécaniques. Afin de pouvoir accepter des dilatations différentielles pour de petites différences de température entre chacun des tubes dues à un manque d'uniformité du chauffage, chaque tube a été réalisé sous forme de lyre (voir FIG.1). La dilatation d'ensemble pour atteindre la température de 700°C du procédé dans le cas du magnésium représentait plus de 65 mm sur l'installation pilote et les lyres ne pouvaient supporter que quelques millimètres de dilatation différentielle. Les tubes ont donc été fixés entre eux mais aussi au creuset et au four de fusion par des brides en inconel (non représenté). L'étanchéité au vide a été obtenue par la superposition d'un joint métallique gonflable suivi d'un joint en graphite.

Enfin, toujours pour des raisons de sécurité, les tubes ont été placés dans une seconde enveloppe A métallique en forme de soufflet (voir FIG.4). Cette seconde enveloppe peu résistante permet de tester l'étanchéité du tube à chaque mise en service et permet de servir de réservoir temporaire en cas de rupture ou fuite sur un tube, le temps de vidanger l'installation et la mettre en sécurité. Dans le cas du revêtement par le zinc, le matériau compatible sera également contenu dans une double enveloppe, dans laquelle, avantageusement, on pourra injecter une atmosphère protégée ou faire le vide, pour protéger les matériaux comme le graphite à haute température.

Le four de fusion 1 est situé à une hauteur inférieure à celle du creuset évaporateur 9. L'effet du vide créé dans l'installation va pomper le métal liquide et va générer une seconde surface libre sur un niveau différent de celui du four de fusion 1. Cela se traduit par une surface d'évaporation située à une altitude différente de celle du four de fusion 1. Cette différence d'altitude dépend de deux caractéristiques principales : la densité du métal, qui dépend également de sa température et la pression atmosphérique. Même si la vanne 7 dans la conduite 8 n'est pas parfaitement étanche, la gravité seule va empêcher le remplissage de l'installation sous vide.

On trouvera ci-après quelques chiffres permettant d'illustrer ceci pour une pression atmosphérique de 1000 mbar. La hauteur manométrique pour une pression d'un bar est égale à 10,33 divisé par la densité du métal (1 bar = 10,33 mètres colonne d'eau).
Densité du magnésium solide : 1,74 kg/dm³. Hauteur manométrique correspondante : 5,93 m.
Densité du magnésium liquide à 660°C: 1,59 kg/dm³. Hauteur manométrique correspondante : 6,50 m.
Densité du magnésium liquide à 700°C : 1,56 kg/dm³. Hauteur manométrique correspondante : 6,62 m.
Densité du zinc solide : 7,18 kg/dm³. Hauteur manométrique correspondante : 1,44 m.

On voit ainsi que, d'un métal à l'autre, la hauteur entre les surfaces libres et donc les équipements peut être très différents. Il existe ainsi un facteur 4,5 entre le zinc et le magnésium.

On voit également, qu'en fonction de la température choisie pour le procédé, la hauteur peut également fortement varier, par exemple plusieurs dizaines de mm pour le magnésium à 660°C et à 700°C.

La pression atmosphérique a également une forte influence car elle représente l'effort qui va s'exercer sur la surface libre du four de fusion, alors que le vide reste absolu. Une variation de 50 mbar de la pression atmosphérique est tout à fait courante et elle peut induire une différence de plus de 70 mm sur la hauteur dans le creuset d'évaporation ou dans les conduites dans le cas du zinc et de plus de 300 mm dans le cas du magnésium.

On a alors opté, selon l'invention, pour un creuset évaporateur se situant à une altitude telle que la dépression générée par le vide ne remplit pas celui-ci, quelle que soit la pression atmosphérique. Quand on fait le vide, avantageusement, le métal fondu ne peut monter dans les conduites d'alimentation 8, de retour 18, 8A qu'à un niveau se situant à quelques dizaines de centimètres sous le creuset évaporateur 9. C'est ensuite la pression générée par la pompe d'alimentation 6 qui remplit le creuset évaporateur 9 jusqu'au niveau nécessaire et prédéterminé pour assurer l'évaporation du métal dans les meilleures conditions possibles. Ce principe ajoute une forte notion de sécurité à l'installation selon la présente invention. En effet, si le vide suffisait à lui seul à maintenir en hauteur une masse importante de métal liquide à haute température (typiquement quelques centaines de kg), le risque de rupture du creuset ou d'une conduite pourrait engendrer la chute de cette importante quantité de métal liquide aussi longtemps qu'on n'a pas forcé la redescente du métal vers le four de fusion 1.

Ici l'arrêt de la pompe d'alimentation 6 ou l'ouverture des vannes engendre la vidange du creuset évaporateur 9 et le niveau retourne automatiquement à sa hauteur manométrique générée par la dépression. Il ne reste alors du métal liquide que dans les conduites, ce qui ne représente que quelques litres.

L'installation selon l'invention comprend enfin une zone déterminée et renforcée 7, 13, 15 dans les conduites 8, 8A et 18, permettant de fondre le magnésium sans provoquer la rupture de la conduite. L'alliage choisi pour ce tronçon de conduite est approprié aux fortes charges et hautes températures. Cette zone appelée « vanne thermique » est munie d'un dispositif de chauffage puissant et d'un dispositif de refroidissement rapide et également régulé permettant de gérer, indépendamment des autres zones (four de fusion, creuset d'évaporation et parties restantes des conduites de métal liquide), la température souhaitée. On peut ainsi solidifier et faire fondre le métal dans cette zone.

Selon la présente invention, les vannes thermiques peuvent être constituées d'une double enveloppe et le refroidissement se fait alors par injection et circulation d'air frais dans la double enveloppe (non représentée).

Selon l'invention, on sait donc réaliser un bouchon métallique solide protégeant l'installation. On sait également maintenir une température assez basse, empêchant ou limitant l'évaporation. On peut donc avoir le four de fusion et le vide au-dessus sans évaporation dans les conduites, ni montée du métal dans celles-ci. On peut ainsi, entre deux campagnes de production, maintenir le four de fusion contenant le métal dans son état fondu sans pour cela avoir le reste de l'installation chauffée et/ou maintenue sous vide. Comme le métal liquide n'est plus présent et jamais solidifié dans les conduites, on peut démonter celles-ci si nécessaire.

L'installation selon l'invention peut en outre être munie des équipements suivants, pris seuls ou en combinaison (FIG.2 et 3) :
- en plus de la vanne de vapeur principale 19, des vannes de vapeur secondaires 22, 23 assurant l'étanchéité et permettant d'avoir la pression atmosphérique dans le creuset tout en ayant le vide dans l'enceinte de dépôt ;
- une armoire de distribution d'argon 37 permettant d'envoyer ce gaz inerte dans le creuset d'évaporation 9 et ainsi repousser le magnésium 11 vers le four de fusion ;
- un compartiment de rétention 43 au bas du creuset d'évaporation ou un creuset d'appoint 44 sur la conduite principale de vapeur mais avant la vanne principale 19, ce creuset étant munis de moyens de chauffage (non représentés) permettant d'avoir de manière localisée la puissance nécessaire pour générer une vapeur de métal à une pression suffisante pour l'évaporation dans les conduites d'alimentation et de retour du métal liquide et partant la solidification du métal liquide dans ces conduites. Le compartiment 43 peut avantageusement être chauffé par les moyens d'induction 42 du creuset ou par tout autre dispositif adapté.

Avec ces divers équipements, le cycle de démarrage est le suivant :
- on démarre la fusion du métal dans le four sans avoir obligation de réaliser préalablement le vide ou de chauffer les conduites et le reste de l'installation ;
- on maintient, dans les vannes thermiques respectives 7, 13, 15, le métal solide et donc à basse température ;
- quand l'installation est prête, c'est-à-dire évacuée et à température pour recevoir le métal liquide et/ou la vapeur, on ferme les vannes de distribution sur les conduites de vapeur et on génère, à une température supérieure à celle que le métal liquide aura dans les conduites et le creuset, de la vapeur métallique via le creuset additionnel 44 sur la conduite à la sortie du creuset ou le compartiment de rétention 43 au bas du creuset d'évaporation. Cette vapeur va remplir le creuset évaporateur 9 et les conduites et empêchera l'évaporation dans les vannes thermiques 7, 13, 15 ou à la surface du liquide montant dans les conduites sous l'effet de la dépression générée par le vide. Par exemple pour le magnésium, on va porter le liquide à une température entre 685 et 690°C et on génère la vapeur au départ du compartiment de rétention 43 ou du creuset d'appoint 44 à 700°C. Pour le liquide ayant tendance à monter, l'atmosphère est déjà saturée et toute évaporation est impossible.

On peut alors arrêter la régulation des vannes thermiques 7, 13, 15 à basse température et fondre le métal se trouvant dans celles-ci en le portant à la température du four. Dès qu'il sera fondu, le métal va monter sous l'effet de la dépression dans les conduites. La pression dans le creuset évaporateur 9 sera le fait de la vapeur métallique générée de quelques mbar et le volume du creuset évaporateur, grand par rapport au volume des conduites permet de conserver cette pression malgré la montée du métal. Le creuset évaporateur peut ensuite être rempli par action sur la pompe d'alimentation 6 et sur les vannes de retour 14 et autres dans le four de fusion 1. Selon une forme préférée de l'invention, on choisit par exemple, comme position des vannes thermiques 7, 13, 15, le même niveau en hauteur que métal liquide dans le four de fusion 1 quand celui-ci est plein et le creuset évaporateur 9 vide. Cela facilite le premier démarrage mais toute autre position entre dans le champ d'application de l'invention.

Pour vidanger l'installation, on effectue les opérations suivantes :
- on ferme la vanne 19 sur la conduite de vapeur ;
- on arrête la pompe d'alimentation 6 et on ouvre les vannes 14, 17 sur les conduites 8, 18 ;
- on peut repousser le métal liquide vers le four de fusion par la pression d'argon. On gère au départ un débit d'argon jusqu'à une pression proche de la pression atmosphérique avant de réguler le débit pour maintenir une pression identique à la pression atmosphérique s'exerçant sur le four de fusion, ceci pour stopper le métal dans les vannes thermiques 7, 13, 15 exactement à la bonne altitude ;
- après une temporisation permettant de s'assurer du bon équilibre de cette situation, on peut couper le chauffage des vannes thermiques et assurer leur refroidissement pour solidifier le métal juste à l'intérieur de celles-ci. On se retrouve donc avec, côté creuset, des surfaces libres froides et inerte ;
- on peut donc arrêter l'installation vidée, sans risque.

La position avec bouchons « congelés » dans les vannes thermiques est dite position de sécurité. Toute anomalie constatée sur l'installation et pouvant être grave génère automatiquement un repli forcé vers cette position (par ex. panne d'un élément chauffant).

L'argon se trouvant dans le creuset peut ensuite être libéré petit à petit vers l'installation de pompage du vide afin de retrouver le bon niveau de vide dans le creuset si on doit redémarrer l'équipement. Dans le cas contraire, l'argon est laissé dans le creuset et constitue un matelas de protection ralentissant l'oxydation des conduites liquides, du creuset d'évaporation et des surfaces libres du métal dans les vannes thermiques.

### Liste des symboles de référence

1 : Four de fusion
2 : Magnésium dans le four de fusion
3 : Vanne d'alimentation
4, 5 : Commande de vanne d'alimentation
6 : Pompe d'alimentation
7 : Vanne thermique d'alimentation
8 : Conduite d'alimentation du creuset
8A : Conduite de trop-plein
9 : Corps du creuset (chauffé par induction)
10 : Dôme du creuset et réserve de vapeur (chauffé par rayonnement)
11 : Magnésium dans le creuset
13 : Vanne thermique sur trop-plein
14 : Vanne de retour
15 : Vanne thermique sur recirculation
16 : Vanne sur trop plein
17 : Vanne de retour
18 : Conduite de recirculation
19 : Vanne principale de distribution de vapeur
20 : Conduite principale d'alimentation en vapeur
21 : Conduites secondaires d'alimentation en vapeur
22 et 23 : Vannes de réglage de débit de vapeur
24 : Enceinte de dépôt
25, 26 : Têtes de revêtement
27, 28 : Compartiment de dépôt
29 : Sonde de niveau pour niveau haut
30 : Sonde de niveau pour niveau bas
31 : Alimentateur en lingots, avec chauffage T1
32 : Vanne de distribution des lingots
33 : Lingots dans le magasin
34 : Lingot en cours de fusion dans le four
35 : Chauffage pour niveau bas
36 : Chauffage pour niveau haut
37 : Armoire de distribution d'argon
38 : Vanne de distribution d'argon
39, 40, 41 : Sondes de niveau pour le creuset
42 : Inducteur de chauffage pour l'évaporation du métal
43 : Compartiment de rétention au fond du creuset évaporateur
44 : Creuset d'appoint pour générer de la vapeur

A : Enveloppe métallique en forme de soufflet
B : Revêtement en inox résistant
C : Tube sans soudure en acier doux

## Revendications

1. Installation de dépôt sous vide en continu d'un revêtement métallique sur un substrat en défilement, comprenant une enceinte de dépôt sous vide (24), au moins une tête de revêtement par jet de vapeur sonique (25, 26) reliée à un creuset évaporateur (9) destiné à contenir le métal de revêtement sous forme liquide (11), par une conduite d'alimentation en vapeur (20) munie d'une vanne de distribution (19), et un four de fusion (1) dudit métal, ledit four se trouvant à la pression atmosphérique, étant situé en contrebas de la partie la plus basse du creuset évaporateur (9) et étant relié au creuset évaporateur (9) par au moins une conduite (8) d'alimentation automatique du creuset évaporateur (9) munie d'une pompe d'alimentation (6) et par au moins une conduite (8A, 18) de retour du métal liquide optionnellement munie d'une vanne (16, 17), des moyens de régulation de la pompe d'alimentation (6) étant en outre présents pour réguler un niveau de métal liquide déterminé dans le creuset évaporateur (9), **caractérisée en ce qu'**elle comprend, dans chacune desdites conduites d'alimentation et de retour (8 ; 8A, 18), une zone appelée vanne thermique (7, 13, 15) munie d'un dispositif de chauffage et d'un dispositif de refroidissement pour obtenir une température régulée, indépendante de celle du four de fusion (1), de celle régnant dans la partie restante desdites conduites (8, 8A, 18) et dans le creuset évaporateur (9), pour fondre ou solidifier le métal se trouvant à cet endroit.

2. Installation selon la revendication 1, comprenant des moyens permettant de générer de la vapeur métallique de façon localisée, entre le four (1) et la tête de revêtement (25, 26).

3. Installation selon la revendication 2, dans laquelle lesdits moyens permettant de générer de la vapeur métallique de façon localisée comprennent un dispositif de rétention de métal liquide (43) situé dans le fond du creuset évaporateur (9).

4. Installation selon la revendication 2, dans laquelle lesdits moyens permettant de générer de la vapeur métallique de façon localisée comprennent un creuset d'appoint (44) relié à la conduite d'alimentation en vapeur (20).

5. Installation selon l'une quelconque des revendications 1 à 4, pour laquelle ladite ou lesdites vannes thermiques sont constituées d'une double enveloppe, dans laquelle se fait le refroidissement par injection et circulation de fluide froid.

6. Installation selon l'une quelconque des revendications 1 à 5, dans laquelle la conduite d'alimentation (8) est munie d'une vanne de dérivation (14) permettant l'utilisation de la conduite d'alimentation (8) comme tube de vidange.

7. Installation selon l'une quelconque des revendications 1 à 6, pour laquelle lesdites conduites (8, 18, 8A) sont réalisées en bi-matière, l'intérieur étant constitué d'un tube sans soudure (C) en acier à bas carbone, en graphite ou en céramique, revêtu ou protégé extérieurement par de l'acier inoxydable (B).

8. Installation selon la revendication 7, pour laquelle les tubes (B, C) sont placés dans une seconde enveloppe métallique en forme de soufflet (A).

9. Installation selon l'une quelconque des revendications 1 à 8, pour laquelle la liaison entre le four de fusion (1) et le creuset évaporateur (9) est assurée par une barre de référence rigide et les conduites (8 ; 8A, 18) sont réalisées en forme de lyre.

10. Installation selon la revendication 9, pour laquelle les conduites sont fixées entre elles ainsi qu'au four (1) et au creuset évaporateur (9) par des brides en métal, l'étanchéité au vide étant obtenue par superposition d'un joint métallique gonflable et d'un joint en graphite.

11. Installation selon l'une quelconque des revendications 1 à 10, comprenant en outre un dispositif de distribution de gaz inerte (37) communiquant avec le creuset évaporateur (9).

12. Procédé de démarrage d'une installation selon l'une quelconque des revendications 2 à 11, selon lequel :
- on démarre la fusion du métal dans le four (1), tout en maintenant du métal à l'état solide dans les vannes thermiques (7, 13, 15) des conduites d'alimentation et de retour (8 ; 8A, 18) ;
- on chauffe le reste de ladite installation jusqu'à la température nécessaire pour recevoir le métal liquide et/ou la vapeur métallique, on ferme la vanne de distribution (19) de la conduite d'alimentation (20), et on met l'enceinte de dépôt (24) sous vide ;
- on active lesdits moyens permettant de générer de la vapeur métallique de façon localisée, à une température supérieure à celle du métal liquide dans l'installation en cours de dépôt;
- on fait fondre le métal solidifié contenu dans les vannes thermiques (7, 13, 15) ;
- on remplit ensuite le creuset évaporateur (9) grâce à la pompe d'alimentation (6), on ouvre la vanne de distribution (19) de la conduite d'alimentation (20), et on commence le dépôt de métal sur ledit substrat en défilement.

13. Procédé selon la revendication 12, pour lequel la hauteur du creuset évaporateur (9) relativement au four de fusion (1) est choisie pour que la surface libre de métal liquide dans la conduite d'alimentation (8) soit située en dessous du creuset (9) lorsque le vide est réalisé dans l'installation, la pompe d'alimentation (6) n'étant pas en fonctionnement.

14. Procédé de mise en oeuvre d'une installation selon l'une quelconque des revendications 1 à 11, pour lequel le substrat est une bande métallique et le revêtement métallique est constitué de magnésium ou de zinc.

## Patentansprüche

1. Einrichtung für das kontinuierliche Vakuumabscheiden einer Metallbeschichtung auf ein vorbeilaufendes Substrat, aufweisend ein Vakuumabscheidungsgehäuse (24), mindestens einen Schall-Dampfstrahl-Beschichtungskopf (25, 26), der über eine Dampfzuführleitung (20), die mit einem Verteilerventil (19) versehen ist, mit einem Verdampfertiegel (9) verbunden ist, der vorgesehen ist, um das Beschichtungsmetall in flüssiger Form (11) zu enthalten, und einen Schmelzofen (1) für das Metall, wobei sich der Ofen unter atmosphärischem Druck befindet, unterhalb des untersten Abschnitts des Verdampfertiegels (9) angeordnet ist und über mindestens eine Leitung (8) zur automatischen Versorgung des Verdampfertiegels (9), die mit einer Zuführpumpe (6) versehen ist, und über mindestens eine Leitung (8A, 18) zum Rückführen des flüssigen Metalls, die optional mit einem Ventil (16, 17) versehen ist, mit dem Verdampfertiegel (9) verbunden ist, wobei ferner Mittel zur Regelung der Zuführpumpe (6) vorgesehen sind, um einen bestimmten Pegel flüssigen Metalls in dem Verdampfertiegel (9) zu regeln, **dadurch gekennzeichnet, dass** sie in jeder der Zuführ- und Rückführleitungen (8, 8A, 18) einen als thermisches Ventil (7, 13, 15) bezeichneten Bereich aufweist, der mit einer Heizvorrichtung und mit einer Kühlvorrichtung versehen ist, um eine geregelte Temperatur unabhängig von derjenigen des Schmelzofens (1), von derjenigen, die in dem verbleibenden Teil der Leitungen (8, 8A, 18) und in dem Verdampfertiegel (9) herrscht, zu erhalten, um das Metall, das sich in diesem Bereich befindet, zu schmelzen oder zu verfestigen.

2. Einrichtung gemäß Anspruch 1, die Mittel aufweist, die ein lokales Erzeugen des Metalldampfes zwischen dem Ofen (1) und dem Beschichtungskopf (25, 26) ermöglichen.

3. Einrichtung gemäß Anspruch 2, wobei die Mittel, die ein lokales Erzeugen des Metalldampfes ermöglichen, eine Vorrichtung zum Zurückbehalten von flüssigem Metall (43) aufweisen, das sich am Boden des Verdampfertiegels (9) befindet.

4. Einrichtung gemäß Anspruch 2, wobei die Mittel, die ein lokales Erzeugen des Metalldampfes ermöglichen, einen Zusatztiegel (44) aufweisen, der mit der Dampfzuführleitung (20) verbunden ist.

5. Einrichtung gemäß irgendeinem der Ansprüche 1 bis 4, bei der das oder die thermischen Ventile doppelwandig ausgebildet sind, wobei das Abkühlen mittels Einspritzens und Zirkulierens eines kühlen Fluids erfolgt.

6. Einrichtung gemäß irgendeinem der Ansprüche 1 bis 5, wobei die Zuführleitung (8) mit einem Ableitungsventil (14) versehen ist, das die Verwendung der Zuführleitung (8) als Auslassrohr ermöglicht.

7. Einrichtung gemäß irgendeinem der Ansprüche 1 bis 6, bei der die Leitungen (8, 18, 18A) aus zwei Materialien realisiert sind, wobei das Innere aus einem Rohr ohne Schweißnaht (C) aus Stahl mit niedrigem Kohlenstoffgehalt, aus Graphit oder aus Keramik gebildet ist, das außen mit rostfreiem Stahl (B) beschichtet oder geschützt ist.

8. Einrichtung gemäß Anspruch 7, bei der die Rohre (B, C) in einer zweiten Metallhülle in Form eines Balgs (A) angeordnet sind.

9. Einrichtung gemäß irgendeinem der Ansprüche 1 bis 8, bei der die Verbindung zwischen dem Schmelzofen (1) und dem Verdampfertiegel (9) durch eine steife Referenzstange sichergestellt ist und die Leitungen (8, 8A, 18) lyraförmig ausgebildet sind.

10. Einrichtung gemäß Anspruch 9, bei der die Leitungen sowohl aneinander als auch an dem Ofen (1) und an dem Verdampfertiegel (9) mittels Metallflanschen befestigt sind, wobei die Vakuumdichtigkeit durch Überlagerung einer aufblasbaren Metalldichtung und einer Graphitdichtung erhalten wird.

11. Einrichtung gemäß irgendeinem der Ansprüche 1 bis 10, ferner aufweisend eine Einrichtung zum Abgeben von Inertgas (37), die mit dem Verdampfertiegel (9) kommuniziert.

12. Verfahren zum Starten einer Einrichtung gemäß irgendeinem der Ansprüche 2 bis 11, bei dem:
- das Schmelzen des Metalls im Ofen (1) gestartet wird, wobei gleichzeitig in den thermischen Ventilen (7, 13, 15) der Zuführ- und Rückführleitungen (8, 8A, 18) Metall in festem Zustand gehalten wird,
- der Rest der Einrichtung bis auf die Temperatur aufgeheizt wird, die erforderlich ist, um das flüssige Metall und/oder den Metalldampf aufzunehmen, das Verteilerventil (19) der Zuführleitung (20) geschlossen wird und das Abscheidungsgehäuse (24) unter Vakuum gesetzt wird,
- die Mittel, die ein lokales Erzeugen des Metalldampfes ermöglichen, bei einer Temperatur von größer als derjenigen des flüssigen Metalls in der Einrichtung während des Abscheidens aktiviert werden,
- das verfestigte Metall, das in den thermischen Ventilen (7, 13, 15) enthalten ist, zum Schmelzen gebracht wird,
- anschließend der Verdampfertiegel (9) mit Hilfe der Zuführpumpe (6) befüllt wird, das Verteilerventil (19) der Zuführleitung (20) geöffnet wird und die Metallabscheidung auf das vorbeilaufende Substrat begonnen wird.

13. Verfahren gemäß Anspruch 12, bei dem die Höhe des Verdampfertiegels (9) in Bezug auf den Schmelzofen (1) derart ausgewählt wird, dass sich die freie Oberfläche von flüssigem Metall in der Zuführleitung (8) unter dem Tiegel (9) befindet, wenn das Vakuum in der Einrichtung realisiert ist, wobei die Zuführpumpe (6) nicht in Betrieb ist.

14. Verfahren zum Einsetzen einer Einrichtung gemäß irgendeinem der Ansprüche 1 bis 11, bei dem das Substrat ein Metallband ist und die Metallbeschichtung aus Magnesium oder aus Zink gebildet ist.

## Claims

1. Facility for continuously vacuum depositing a metal coating on a moving substrate, comprising a vacuum deposition enclosure (24), at least one sonic vapour jet coating head (25, 26) connected to an evaporator pot (9) designed to contain the coating metal in liquid form (11) by a vapour supply pipe (20) provided with a distribution valve (19), and a furnace (1) for melting said metal, said furnace being at atmospheric pressure, being disposed at a level below the lowest part of the evaporator pot (9) and being connected to the evaporator pot (9) by at least one pipe (8) provided with a supply pump (6) for automatically supplying the evaporator pot (9) and by at least one return pipe (8A, 18) for the liquid metal optionally provided with a valve (16, 17), means for controlling the supply pump (6) also being provided as a means of regulating a given liquid metal level in the evaporator pot (9), **characterised in that** it comprises, in each of said supply and return pipes (8; 8A, 18), a so-called heat valve area (7, 13, 15) provided with a heating device and a cooling device for obtaining a regulated temperature, independent of that of the melting furnace (1), that prevailing in the remaining part of said pipes (8, 8A, 18) and in the evaporator pot (9) in order to melt or solidify the metal disposed on this area.

2. Facility as claimed in claim 1, comprising means enabling metal vapour to be generated on a localised basis between the furnace (1) and the coating head (25, 26).

3. Facility as claimed in claim 2, in which said means enabling metal vapour to be generated on a localised basis comprise a device (43) for containing liquid metal disposed at the bottom of the evaporator pot (9).

4. Facility as claimed in claim 2, in which said means enabling metal vapour to be generated on a localised basis comprise a top-up pot (44) connected to the vapour supply pipe (20).

5. Facility as claimed in any one of claims 1 to 4, for which said heat valve or valves comprise a double jacket in which cooling takes place by injecting and circulating cold fluid.

6. Facility as claimed in any one of claims 1 to 5, in which the supply pipe (8) is provided with a bypass valve (14) enabling the supply pipe (8) to be used as a drainage tube.

7. Facility as claimed in any one of claims 1 to 6, for which said pipes (8, 18, 8A) are made from a dual material, the interior comprising a non-welded tube (C) of low-carbon steel, graphite or ceramic, coated with or protected by stainless steel (B) on the outside.

8. Facility as claimed in claim 7, for which the tubes (B, C) are placed in a second metal jacket in the form of a bellows (A).

9. Facility as claimed in any one of claims 1 to 8, for which the connection between the melting furnace (1) and the evaporator pot (9) is established by a rigid reference bar and the pipes (8; 8A, 18) are made in the shape of a lyre.

10. Facility as claimed in claim 9, for which the pipes are secured to one another as well as to the furnace (1) and evaporator pot (9) by metal flanges, the vacuum seal being obtained by superposing an inflatable metal seal and a graphite seal.

11. Facility as claimed in any one of claims 1 to 10, further comprising a device (37) for distributing inert gas communicating with the evaporator pot (9).

12. Method of starting up a facility as claimed in any one of claims 2 to 11, whereby:
- the process of melting the metal in the furnace (1) is initiated whilst keeping the metal in the heat valves (7, 13, 15) of the supply and return pipes (8; 8A, 18) in the solid state;
- the rest of said facility is heated to the temperature needed to receive the liquid metal and/or metal vapour, the distribution valve (19) of supply pipe (20) is closed and the deposition enclosure (24) is placed under vacuum;
- said means for generating metal vapour on a localised basis are activated at a temperature greater than that of the liquid metal in the process of being deposited in the facility;
- the solidified metal contained in the heat valves (7, 13, 15) is melted;
- the evaporator pot (9) is then filled using the supply pump (6), the distribution valve (19) of supply pipe (20) is opened and deposition of the metal on said moving substrate is commenced.

13. Method as claimed in claim 12, for which the height of the evaporator pot (9) relative to the melting furnace (1) is selected so that the free surface of the liquid metal in the supply pipe (8) is disposed below the pot (9) when the facility is placed under vacuum, the supply pump (6) not being in operation.

14. Method of operating a facility as claimed in any one of claims 1 to 11, for which the substrate is a metal strip and the metal coating is magnesium or zinc.
